# EUROPEAN PATENT APPLICATION

(11) **EP 1 826 836 A1**
(43) Date of publication of application: **29.08.2007**
(21) Application number: 05783565.4
(22) Date of filing: 14.09.2005
(51) Int. Cl.: H01L 51/00

(54) **PROCESS FOR PRODUCING ORGANIC ELECTROLUMINESCENCE DISPLAY AND APPARATUS THEREFOR**

(30) Priority: 17.12.2004 JP 2004366403
(71) Applicant: SHARP KABUSHIKI KAISHA, Osaka-shi, Osaka 545-8522 (JP)
(72) Inventor: ISHIDA, Kazuya, Soraku-gun, Kyoto 6190216 (JP); OKANO, Kiyoshi, Suzuka-shi, Mie 513-0827 (JP); KISHIMOTO, Kazuyuki, Nara-shi, Nara 6310074 (JP); GOUDA, Tadashi, Suzuka-shi, Mie 513-0824 (JP); YAMAMOTO, Emi, Nara-shi, Nara 6310846 (JP)
(74) Representative: Brown, Kenneth Richard
(86) International application number: PCT/JP2005/016958
(87) International publication number: WO 2006/064600

(57) **Abstract**

A method for fabricating an organic electroluminescent display includes the formation step of forming an organic electroluminescent layer in an electroluminescent layer formation chamber including an air atmosphere having a lower ozone concentration than the ambient atmosphere.

## Description

### TECHNICAL FIELD

The present invention relates to methods and apparatuses for fabricating organic electroluminescent displays.

### BACKGROUND ART

Organic electroluminescent displays (which will be hereafter occasionally referred to as "organic EL displays") are each configured such that an organic electroluminescent layer (which will be occasionally referred to as an "organic EL layer") including at least an organic electroluminescent light emitting layer (which will be hereafter occasionally referred to as an "organic EL light emitting layer") is held between a cathode and an anode. The cathode injects electrons into the organic EL light emitting layer and the anode injects holes (positive holes) into the organic EL light emitting layer. In the organic EL light emitting layer, electrons and holes injected by the cathode and the anode, respectively, recombine to form excitons. Then, when the formed excitons are devitalized, light is emitted from the organic EL light emitting layer. Utilizing this light emission, the organic EL display displays letters, images and the like.

Organic EL displays can be operated at a low driving voltage and have an excellent fast-response property. Moreover, organic electroluminescent displays are self-luminous and have a wide viewing angle. Therefore, organic EL displays are largely expected to be next generation flat panel displays and there have been increased development for various kinds of organic EL displays and fabrication methods which allow mass production for organic EL displays.

Such organic EL displays are largely divided into two kinds depending on types of the organic EL layer. Specifically, they are largely divided into two types of the organic EL layers, i.e., low molecular organic EL displays including an EL layer containing a low molecular organic electroluminescent material and high molecular organic EL displays including an organic EL layer containing a high molecular organic electroluminescent material (which will be hereafter occasionally referred to as a "high molecular organic EL material"). The organic EL layer containing a high molecular organic EL material is formed by wet processing such as print processing, an inkjet method (e.g., Patent References 1 and 2) or any other method.

In general, the high molecular organic EL material contained in the organic EL layer is very likely to be deteriorated in the ambient atmosphere. Therefore, when the organic EL layer is formed in the ambient atmosphere, the organic EL material is deteriorated in the process for forming the organic EL layer. This makes it difficult to provide innate characteristics of the organic EL layer (luminous brightness, luminous efficiency, brightness half-life, luminous life, and other characteristics).

In view of the above-described problems, various techniques for controlling the atmosphere used in process steps for fabricating an organic EL display including the process step of forming an organic EL layer have been proposed. For example, in Patent Reference 3, a technique is disclosed which includes the process step of transferring an organic electroluminescent lamination structure formed in the process step of forming an organic electroluminescent lamination structure to the process step of imposing a shield member in vacuum or an inert gas atmosphere having a water content of 100 ppm or less without exposing the organic electroluminescent lamination structure to the atmosphere.

Disclosed in Patent Reference 4 is a technique characterized in that process steps from an initial process step of forming an organic layer to the process step of forming a sealing portion are performed in an atmosphere of which a water volume is limited. Also, in Patent Reference 5, a technique in which the process step of discharging a luminous function material is carried out in an inert gas atmosphere is disclosed.

Patent Reference 1: Japanese Unexamined Patent Publication No. 10-12377
Patent Reference 2: Japanese Unexamined Patent Publication No. 10-153967
Patent Reference 3: Japanese Unexamined Patent Publication No. 10-241858
Patent Reference 4: Japanese Unexamined Patent Publication No. 2003-77655
Patent Reference 5: Japanese Unexamined Patent Publication No. 2003-217840

However, as in the methods disclosed in Patent References 3 through 5, when the organic EL layer is formed in an atmosphere in which oxygen and water are not substantially contained, for example, in a vacuum atmosphere or an inert gas atmosphere, the process step of forming the organic EL layer has to be performed in an closed space such as a globe box and the like. In experimental and trial stages of production, the organic EL layer can be formed in a globe box, but in a mass production process step, it is difficult to form the organic EL layer in a globe box in terms of productivity (production efficiency) and production costs.

In view of the above-described problems, the present invention has been devised and it is therefore an object of the present invention to provide a method for fabricating an organic EL display having high luminous efficiency and a long production-life at low cost and with high production efficiency.

### DISCLOSURE OF THE INVENTION

In known techniques, it has been considered that a major cause of not being able to achieve innate characteristics of the organic EL layer when the organic EL layer is formed in an atmosphere is that the organic EL material is in contact with oxygen and moisture. As a result of diligent studies, however, the present inventors found that a major cause of not being able to achieve innate characteristics of the organic EL layer is that the organic EL material is in contact with ozone. The present inventors found that a decrease in the concentration of ozone in an atmosphere in which the organic EL layer is formed effectively restrains the characteristics of the organic EL layer from being deteriorated in the process step of forming the organic EL layer, and thus the present inventor has reached the present invention.

A method for fabricating an organic electroluminescent display of the present invention is a method for fabricating an organic electroluminescent display including an organic electroluminescent layer provided between a pair of electrodes. The method of the present invention includes the formation step of forming the organic electroluminescent layer in an electroluminescent layer formation chamber including an air atmosphere having a lower ozone concentration than the ambient atmosphere.

In this fabrication method, the step of forming an organic EL layer can effectively suppress contact of an organic EL material with ozone. Therefore, an organic EL display having high luminous efficiency and a long product-life can be fabricated.

An air atmosphere having a lower ozone concentration than the ambient atmosphere can be comparatively easily formed and comparatively easily maintained. For example, the electroluminescent layer formation chamber (which will be hereafter occasionally referred to as an "EL layer formation chamber") does not need to be a large-scale chamber, such as a globe box. Furthermore, an inert gas requiring a large amount of running cost does not need to be sent into the EL layer formation chamber. Therefore, according to the fabrication method of the present invention, an organic EL display having excellent characteristics can be fabricated at low cost. Since the EL layer formation chamber does not have to be a closed space, such as a globe box, high production efficiency (high workability and high transportability) can be achieved.

The method of the present invention may further include the sending step of sending adjusted air having a lower ozone concentration than the ambient atmosphere into the electroluminescent layer formation chamber. The sending step may be carried out prior to or simultaneously with the formation step.

The sending step may include the adjustment step of adjusting the ozone concentration in the adjusted air using an ozone reducer for reducing the ozone concentration. The ozone reducer includes an adjuster for adjusting air so as not to substantially contain ozone. The ozone reducer may have the functions of decomposing ozone and absorbing ozone. Specifically, the ozone reducer may be an ozone filter.

The method of the present invention may further include the reduction step of allowing the electroluminescent layer formation chamber to have a lower ozone concentration than the ambient atmosphere. The reduction step may be carried out prior to or simultaneously with the formation step.

In the method of the present invention, the electroluminescent layer formation chamber preferably has an ozone concentration of 30 ppb or less during the formation of the organic electroluminescent layer. When the electroluminescent layer formation chamber has an ozone concentration of 30 ppb or less, an organic electroluminescent display having more excellent characteristics (luminous efficiency, luminous brightness, luminous life, and other characteristics) can be fabricated.

An organic electroluminescent display of the present invention is fabricated by the method of the present invention. As described above, according to the method of the present invention, an organic EL display having excellent characteristics can be fabricated at low cost and with high production efficiency. In other words, the organic EL display of the present invention can be fabricated at low cost and with high production efficiency to have excellent characteristics.

A fabrication apparatus according to a first aspect of the present invention relates to an apparatus for fabricating an organic EL display including an organic electroluminescent layer. The apparatus of the first aspect includes an electroluminescent layer formation chamber for forming the organic electroluminescent layer, and an adjusted air injector for sending adjusted air having a lower ozone concentration than the ambient atmosphere into the electroluminescent layer formation chamber during the formation of the organic electroluminescent layer. According to the apparatus of the first aspect of the present invention, the adjusted air having a low ozone concentration can be sent into the EL layer formation chamber for forming an EL layer. This allows the EL layer formation chamber to have a lower ozone concentration than the ambient atmosphere during the formation of the organic EL layer. In view of the above, according to the apparatus of the first aspect of the present invention, an organic EL material can be effectively restrained from being deteriorated due to ozone during the formation of the organic EL layer. Therefore, an organic EL display having high luminous efficiency and a long production-life can be fabricated.

In the apparatus of the first aspect of the present invention, the adjusted air injector may include an ozone reducer for reducing the ozone concentration. The ozone reducer includes an ozone remover for allowing the ozone concentration in the adjusted air to substantially become zero. The ozone reducer may have the functions of decomposing ozone and absorbing ozone. Specifically, the ozone reducer may be an ozone filter.

The adjusted air injector may include a pump for sending air by the application of pressure and an ozone filter through which the air passes.

In the apparatus of the first aspect of the present invention, the electroluminescent layer formation chamber preferably has an ozone concentration of 30 ppb or less during the formation of the organic electroluminescent layer. With this configuration, an organic electroluminescent display having more excellent characteristics (luminous efficiency, luminous brightness, luminous life, and other characteristics) can be fabricated.

A fabrication apparatus according to a second aspect of the present invention relates to an apparatus for fabricating an organic electroluminescent display including an organic electroluminescent layer. The apparatus of the second aspect of the present invention includes an electroluminescent layer formation chamber for forming the organic electroluminescent layer, and an ozone reducer for allowing the electroluminescent layer formation chamber to have a lower ozone concentration than the ambient atmosphere during the formation of the organic electroluminescent layer.

According to the apparatus of the second aspect of the present invention, the EL layer formation chamber can be adjusted by the ozone reducer to have a lower ozone concentration than the ambient atmosphere. An organic EL layer can be formed in the EL layer formation chamber adjusted to have a lower ozone concentration than the ambient atmosphere. Thus, use of the apparatus of the second aspect of the present invention can effectively restrain an organic EL material from being deteriorated due to ozone during the formation of the organic EL layer. In view of the above, according to the apparatus of the second aspect of the present invention, an organic EL display having high luminous efficiency and a long production-life can be fabricated.

The ozone reducer may have the functions of decomposing ozone and absorbing ozone. Specifically, the ozone reducer may be an ozone filter.

In the apparatus of the second aspect of the present invention, the electroluminescent layer formation chamber preferably has an ozone concentration of 30 ppb or less during the formation of the organic electroluminescent layer. With this configuration, an organic electroluminescent display having more excellent characteristics (luminous efficiency, luminous brightness, luminous life, and other characteristics) can be fabricated.

### BRIEF DESCRIPTION OF DRAWINGS

[FIG. **1]** FIG. **1** is a schematic view illustrating the configuration of a fabrication apparatus according to a first embodiment.
[FIG. **2]** FIG. **2** is a flow chart for explaining the process step of forming an EL layer.
[FIG. **3]** FIG. **3** is a schematic view illustrating the configuration of a fabrication apparatus according to a second embodiment.
[FIG. **4]** FIG. **4** is a flow chart illustrating the process step of forming an organic EL layer according to a second embodiment.
**[FIG. 5]** FIG. **5** is a schematic cross-sectional view of an organic EL display according to each of Implementation examples and Comparison examples.
[FIG. **6]** FIG. **6** is a graph showing the correlation between the ozone concentration during the formation of an organic EL layer and luminous efficiency for each of the implementation examples 1 through 4 and the comparison examples 1 and 2 in which a green light emitting material is used.
[FIG. **7]** FIG. 7 is a graph showing the correlation between the ozone concentration during the formation of an organic EL layer and luminous efficiency for each of the implementation examples 5 through 8 and the comparison examples 3 and 4 in which a blue light emitting material is used.

### BEST MODE FOR CARRYING OUT THE INVENTION

Hereafter, embodiments of the present invention will be described in detail.

### (Embodiment 1)

Process steps for fabricating an organic EL display according to a first embodiment of the present invention will be described in detail. First, a plurality of TFTs and a plurality of anodes (pixel electrodes) are formed, in a matrix pattern, on an insulating substrate formed of glass, plastic and any other material. The anodes can be formed of indium tin oxide (ITO) or any other material. A bank is formed to isolate the plurality of anodes from one another, and a buffer layer (hole transport layer) is formed on each anode. The buffer layer has the functions of injecting carriers (holes) into an organic EL light emitting layer and absorbing the surface roughness of the anode to form a flat plane.

For example, a mixture of polyethylene dioxithiophene and polysulfonic acid (PEDOT/PSS, for example BAYTRON P CH8000 available from H. C. Starck-VTECH Ltd., Poly-TPD (poly(N,N'-bis-(4-butylphenyl)-N,N'-bis(phenyl)benzidine), PANI-CSA and the like can be used as a material for the buffer layer.

An organic light emitting layer is formed on the buffer layer. For example, polyfluorene compound, polyphenylenevinylene compound, polyspiro compound, poly-paraphenylene compound, polythiophene compound and the like represented by a compound (which will be hereafter occasionally referred to a "compound A") expressed by the following chemical formula 1 can be used as a material of the organic EL light emitting layer.

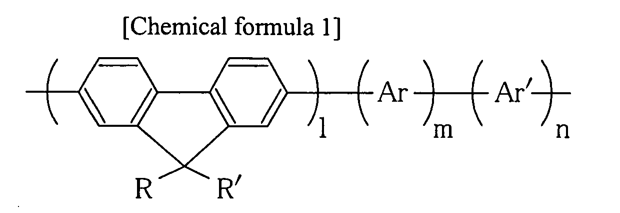

(Where each of R and R' is an alkyl chain and each of Ar and Ar' is an aromatic aryl compound. Each of 1 and m is an integer number of 1 or more and n is an integer of 0, 1 or more. The molecular weight is 50,000 or more and 500,000 or less.)
Note that in Chemical formula 1, the aromatic aryl compound may be dimethylbenzene, pyridine, benzene, anthracene, spirobiflorene, carbazole, benzoamine, bipyridine, benzothiadiazole or the like. A luminescent color of the compound A varies depending on types of Ar and Ar' and the ratio of 1 : m : n in Chemical formula 1.

Note that the buffer layer and the organic EL light emitting layer can be formed by wet processing, print processing, laser transfer or the like. Spin coating, inkjet method, nozzle coating, slit coating, die coating, and the like are examples of wet processing. Off-set printing and intaglio printing are examples of print processing.

Finally, a cathode is formed on the organic EL light emitting layer and then an associated organic EL layer is encapsulated by a glass cap or the like in an inert gas atmosphere such as nitrogen or the like. Thus, an organic EL display can be completed. The cathode can be formed by depositing indium tin oxide (ITO) or any other material using vapor deposition or any other method.

In the organic EL display, the organic EL layer is formed of the buffer layer (hole transport layer) and the organic EL light emitting layer. However, it may consist of only an organic EL light emitting layer. Alternatively, it may further include a hole injection layer, an electron transport layer, an electron injection layer, and other layers.

Next, the process step of forming the organic EL layer including the buffer layer and the organic EL light emitting layer in the first embodiment will be described in detail.

In the first embodiment, an organic EL layer including a buffer layer and an organic EL light emitting layer is formed in a chamber for forming an EL layer (hereinafter, referred to as "EL layer formation chamber"). The chamber has a lower ozone concentration than the ambient atmosphere.

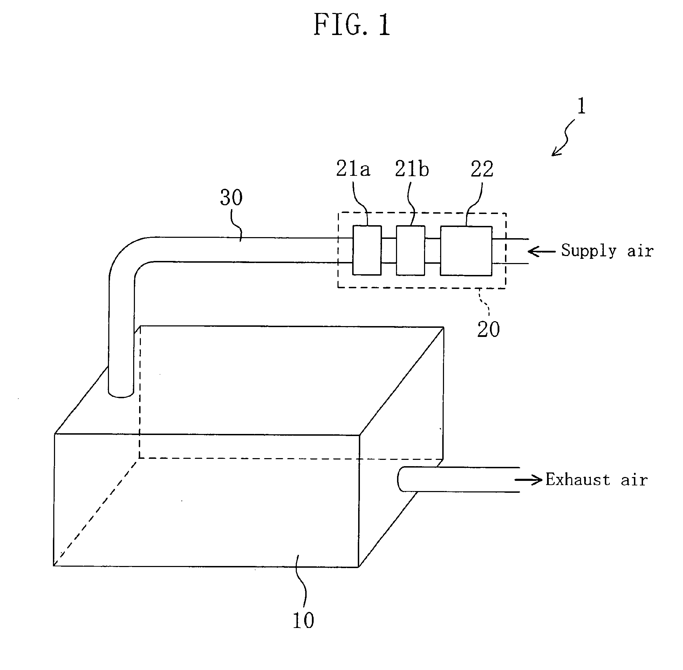

**FIG.** 1 is a schematic view illustrating the configuration of a fabrication apparatus **1** for an organic EL display of the first embodiment.

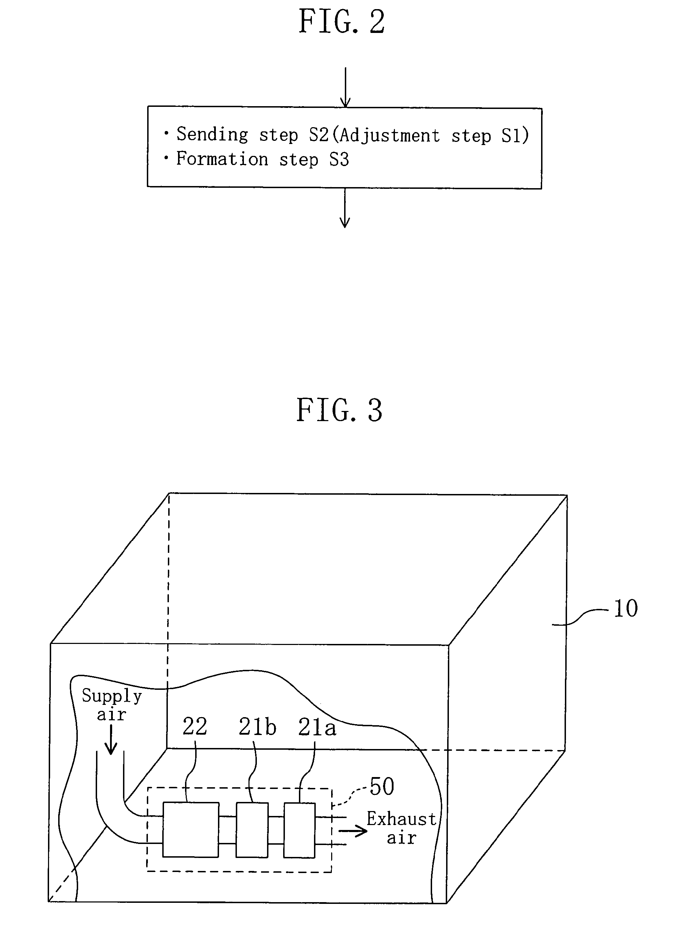

FIG. 2 is a flow chart for explaining the process step of forming an EL layer.

The fabrication apparatus **1** includes an EL layer formation chamber **10** for forming an organic EL layer, an adjusted air injector **20,** a duct **30** through which the EL layer formation chamber **10** communicates with the adjusted air injector **20,** and an organic EL layer formation unit (not shown), such as an inkjet apparatus. The adjusted air injector **20** includes an ozone filter **21a** serving as an ozone reducer, a clean filter **21b** for filtering dusts and the like, and a pump **22.** The adjusted air injector **20** allows adjusted air having a lower ozone concentration than the ambient atmosphere to be sent into the EL layer formation chamber **10.**

The ozone filter **21a** has the function of absorbing and/or decomposing ozone to reduce the ozone concentration in the adjusted air. The ozone filter **21a** may include both or any one of an ozone decomposition catalyst and activated carbon having the function of absorbing ozone.

Air containing ozone in the ambient atmosphere is sent into the adjusted air injector **20.** Impurities, such as dusts, are removed from the sent air by the clean filter **21b** included in the adjusted air injector **20.** Thereafter, the resultant air is adjusted by the ozone filter **21a** to have a lower ozone concentration than the ambient atmosphere (adjustment step, Step 1). The so adjusted air is sent into the EL layer formation chamber 10 by the function of the pump **22** (sending step, Step 2). This allows the EL layer formation chamber **10** to include an air atmosphere having a lower ozone concentration than the ambient atmosphere. Then, an organic EL layer is formed on a substrate in the EL layer formation chamber **10** (formation step, Step 3). This formation step permits the formation of an organic EL layer while restraining an organic EL material from being deteriorated due to ozone. Therefore, an organic EL display having high luminous efficiency and a long production-life can be fabricated.

During the formation of an organic EL layer, the adjusted air injector **20** may send the adjusted air into the EL layer formation chamber **10** only prior to the formation step or at all the time. Alternatively, it may send the adjusted air into the EL layer formation chamber **10** intermittently as necessary. For example, the ozone concentration in the EL layer formation chamber **10** may be monitored, and when it exceeds a predetermined value, the adjusted air may be sent into the EL layer formation chamber **10** for a predetermined period of time.

The characteristics of an organic EL layer (luminous efficiency, luminous life and other characteristics) are correlated with the ozone concentration in the EL layer formation chamber **10.** More specifically, with a reduction in the ozone concentration in the EL layer formation chamber **10,** the characteristics of an available organic EL layer is improved. In particular, when the EL layer formation chamber **10** has an ozone concentration of 50 ppb through 30 ppb, the characteristics of an available organic EL layer significantly vary. When the EL layer formation chamber **10** has an ozone concentration of 30 ppb or less, an organic EL layer having particularly preferable characteristics can be formed. It is further preferable that the EL layer formation chamber **10** has an ozone concentration of 20 ppb or less.

The ozone concentration in the ambient atmosphere varies according to the season and time but generally within the range from 30 ppb to 50 ppb. Therefore, even when the ambient atmosphere has a maximum ozone concentration of approximately 50 ppb, approximately 40 percent of the ozone in the ambient atmosphere is removed by the ozone filter **21a,** thereby producing a favorable atmosphere in the EL layer formation chamber **10.** The adjustment of the ozone concentration to the above-mentioned extent can be sufficiently achieved without using, as the EL layer formation chamber **10,** a globe box completely isolated from outside air. In view of the above, high workability and productivity can be achieved. Since an inert gas requiring running cost does not need to be sent into the EL layer formation chamber **10,** an organic EL display can be fabricated in a simple manner at low cost.

The process step of forming an organic EL layer includes the step of depositing an organic EL material forming an organic EL layer by coating or any other method and the step of drying a thin film made of the deposited organic EL material to complete an organic EL layer. At least the step of depositing the organic EL layer is preferably carried out in an EL layer formation chamber **10** having a low ozone concentration. Both of the steps of depositing the organic EL layer and drying the thin film are more preferably carried out in the EL layer formation chamber **10.** After the formation of the organic EL layer, the step of moving the organic EL layer to a chamber maintained under vacuum to deposit an associated cathode on the organic EL layer is also further preferably carried out under an adjusted air atmosphere. Thus, an organic EL display having higher luminous efficiency and a longer production-life can be fabricated.

The ozone concentration in the EL layer formation chamber **10** can be measured by ultraviolet absorption spectrometry using an ozone concentration meter, such as MODEL 1200 available from Dylec, Inc.

### (Embodiment 2)

FIG. **3** is a schematic view illustrating the configuration of a fabrication apparatus **2** according to a second embodiment of the present invention.

As illustrated in FIG. **3,** a fabrication apparatus **2** of the second embodiment has the same configuration as the fabrication apparatus **1** of the first embodiment with the exception that a reducer **50** is used instead of the adjusted air injector **20.** In this embodiment, the reducer **50** that is not provided with the fabrication apparatus **1** of the first embodiment will be described in detail. Components having substantially the same functions as those of the first embodiment are denoted by the same reference numerals, and thus descriptions thereof will be omitted.

The reducer **50** is provided inside an EL layer formation chamber **10** and, like the adjusted air injector **20** of the first embodiment, includes an ozone filter **21a** serving as an ozone reducer, a clean filter **21b** and a pump **22.** The function of the pump **22** allows air in the EL layer formation chamber **10** to be sucked into the reducer **50.** Dusts and the like are removed from the sucked air by the clean filter **21b.** Air is adjusted by the ozone filter **21a** to have a lower ozone concentration than the ambient atmosphere, and the adjusted air is discharged from the reducer **50.** In other words, the atmosphere in the EL layer formation chamber **10** is circulated while the ozone concentration in the chamber **10** is reduced by the reducer **50.** Use of this reducer **50** allows the EL layer formation chamber **10** to include an air atmosphere having a lower ozone concentration than the ambient atmosphere.

Next, the process step of forming an organic EL layer using the fabrication apparatus **2** will be described.

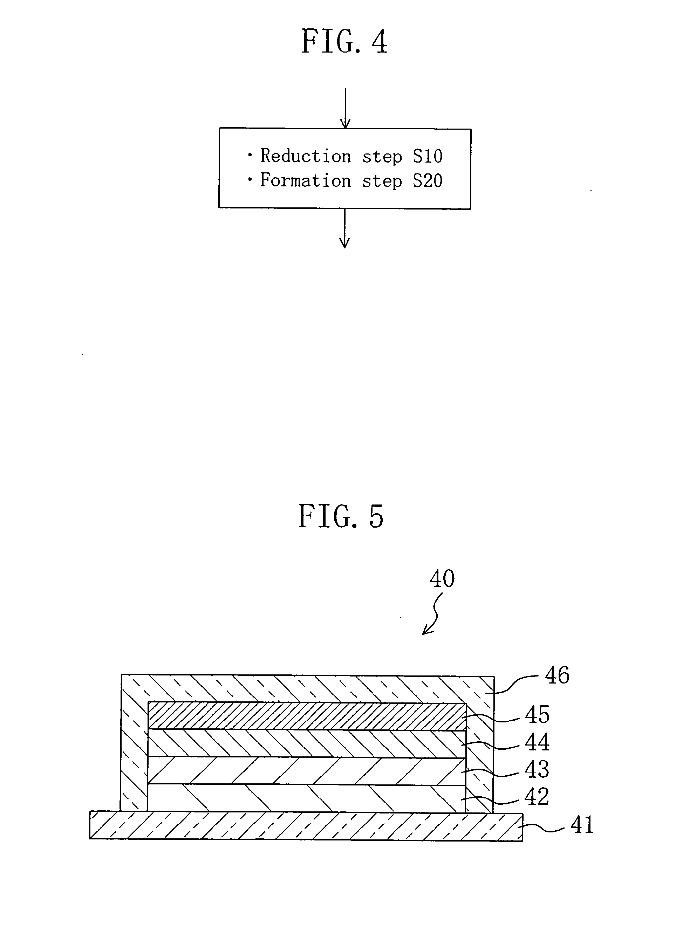

FIG. **4** is a flow chart illustrating the process step of forming an organic EL layer according to the second embodiment.

A reducer **50** is operated so that the ozone concentration in an EL layer formation chamber **10** is made lower than that in the ambient atmosphere (reduction step, Step 10). After or during this reduction step, an EL layer is formed on a substrate in the EL layer formation chamber (formation step, Step 20). Thus, in the second embodiment, like the first embodiment, an organic EL layer can be formed while an organic EL material contained in the organic EL layer is restrained from being in contact with ozone. In view of the above, an organic EL display having high luminous efficiency and a long production-life can be fabricated.

### IMPLEMENTATION EXAMPLES

FIG. **5** is a schematic cross-sectional view illustrating an organic EL display **40** according to implementation examples and comparison examples.

The organic EL display **40** includes a glass substrate **41,** an anode **42** formed on the glass substrate **41,** a buffer layer **43** formed on the anode **42,** an organic EL light emitting layer **44** formed on the buffer layer **43,** a cathode **45** formed on the organic EL light emitting layer **44,** and a sealing cap **46** in which the anode **42,** the buffer layer **43,** the organic EL light emitting layer **44,** and the cathode **45** are encapsulated so as to be isolated from outside air. Organic EL displays **40** were formed according to the following fabrication method under different atmosphere conditions with various different ozone concentrations for forming a buffer layer **43** and an organic EL light-emitting layer **44.** The obtained organic EL displays are indicated as Implementation examples 1 through 8 and Comparison examples 1 through 4.

First, an anode **42** of indium tin oxide (ITO) was formed on a glass substrate **41** (available from Asahi Glass Company) by sputtering. The anode **42** had a thickness of 200 nm. Using an inkjet method, a buffer layer **43** containing a mixture of polyethylene dioxithiophene and polysulfonic acid (PEDOT/PSS, for example BAYTRON P CH8000 available from H. C. Starck-VTECK Ltd.) was formed on the anode **42.** Specifically, in each of Implementation examples 1 through 4 and Comparison examples 1 and 2, an ink for forming the buffer layer **43** had a composition containing 6 wt part of PEDOT/PSS, 5 wt part of water, 5 wt part of ethanol, and 5 wt part of ethylene glycol. In each of Implementation examples 5 through 8 and Comparison examples 3 and 4, the ink for forming the buffer layer **43** had a composition containing 6 wt part of PEDOT/PSS and 4 wt part of water. A film of an ink containing PEDOT/PSS was formed, and then the ink film was baked at 200°C for 10 minutes, thereby forming a buffer layer **43.** In each of Implementation examples 1 through 4 and Comparison examples 1 and 2, the formed buffer layer **43** had a thickness of 80 nm. In each of Implementation examples 5 through 8 and Comparison examples 3 and 4, the formed buffer layer **43** had a thickness of 40 nm.

An organic EL light emitting layer **44** containing a compound A expressed by the Chemical formula 1 was formed on the buffer layer **43** using an inkjet method. Specifically, in each of Implementation examples 1 through 4 and Comparison examples 1 and 2, an ink for forming the organic EL light emitting layer **44** had a composition of 8 wt part of the compound A, 500 wt part of tetraphosphorus and 500 wt part of xylene. In each of Implementation examples 5 through 8 and Comparison examples 3 and 4, the ink had a composition of 1 wt part of the compound A and 100 wt part of xylene. After application of the ink containing the compound A, the ink was baked at 200°C for 60 minutes to form an organic EL light emitting layer **44.** In each of Implementation examples 1 through 4 and Comparison examples 1 and 2, the formed organic EL light emitting layer **44** had a thickness of 80 nm. In each of Implementation examples 5 through 8 and Comparison examples 3 and 4, the formed organic EL light emitting layer **44** had a thickness of 60 nm.

A cathode 45 was formed on the organic EL light emitting layer **44** by vacuum deposition. In each of Implementation examples 1 through 4 and Comparison examples 1 and 2, the cathode 45 was composed of a 5-nm-thick calcium layer and a 100-nm-thick silver layer. In each of Implementation examples 5 through 8 and Comparison examples 3 and 4, the cathode **45** was composed of a 2-nm-thick lithium fluorine layer, a 2-nm-thick calcium layer, and a 100-nm-thick silver layer.

Thereafter, in a nitrogen atmosphere, the glass substrate **41** was sealed by a sealing cap **46** made of glass (available from Asahi Glass Company), thereby completing an organic EL display **40.** Note that the glass substrate **41** and the sealing cap **46** were adhered with a UV curable resin.

The formation of the buffer layer **43** and the organic EL light-emitting layer **44** (the steps of depositing and drying the layers) were carried out in adjusted air having a controlled ozone concentration. The adjusted air was adjusted by an ozone filter (available from Toyobo Co., Ltd.). The ozone concentration in the atmosphere in which the buffer layer **43** and the organic EL light emitting layer **44** are formed was measured by ultraviolet absorption spectrometry using MODEL 1200 available from Dylec, Inc. The ozone concentration in the atmospheres in which a buffer layer **43** and an organic EL light emitting layer **44** are formed for each of Implementation examples and Comparison examples is indicated in the following Table 1.

For organic EL displays according to Implementation examples 1 through 8 and Comparison examples 1 through 4 fabricated in the above-described manner, luminous efficiency and brightness half-life were measured. Luminous efficiency was measured using an organic EL property measuring device available from Otsuka Electronics Co., Ltd. Brightness half-life was measured using an organic EL aging measuring device available from Otsuka Electronics Co., Ltd. Note that "brightness half-life" means a time which it takes for an initial brightness to drop to half the initial brightness. In each of Implementation examples 1 through 4 and Comparison examples 1 and 2 in which a green light emitting material was used, an initial brightness is set to be 8000 cd/m². In each of Implementation examples 5 through 8 and Comparison examples 3 and 4 in which a blue light emitting material was used, an initial brightness is set to be 1500 cd/m².

Table 1 shows luminous efficiency and brightness half-life for the implementation examples 1 through 8 and the comparison examples 1 through 4.

**[Table 1]**

| | Used Light emitting material | Ozone concentration during layer formation (ppb) | Luminous efficiency (cd/A) | Brightness half-life (Hr) |
|---|---|---|---|---|
| Implementation Example 1 | Green | <3 | 11 | 120 |
| Implementation Example 2 | Green | 10 | 10.8 | 121 |
| Implementation Example 3 | Green | 20 | 10.2 | 111 |
| Implementation Example 4 | Green | 30 | 9.4 | 99 |
| Comparison Example 1 | Green | 40 | 6.4 | 57 |
| Comparison Example 2 | Green | 50 | 3.3 | 18 |
| Implementation Example 5 | Blue | <3 | 5.4 | 68 |
| Implementation Example 6 | Blue | 10 | 5.4 | 66 |
| Implementation Example 7 | Blue | 20 | 5.1 | 62 |
| Implementation Example 8 | Blue | 30 | 4.2 | 48 |
| Comparison Example 3 | Blue | 40 | 2.1 | 11 |
| Comparison Example 4 | Blue | 50 | 0.9 | 3 |

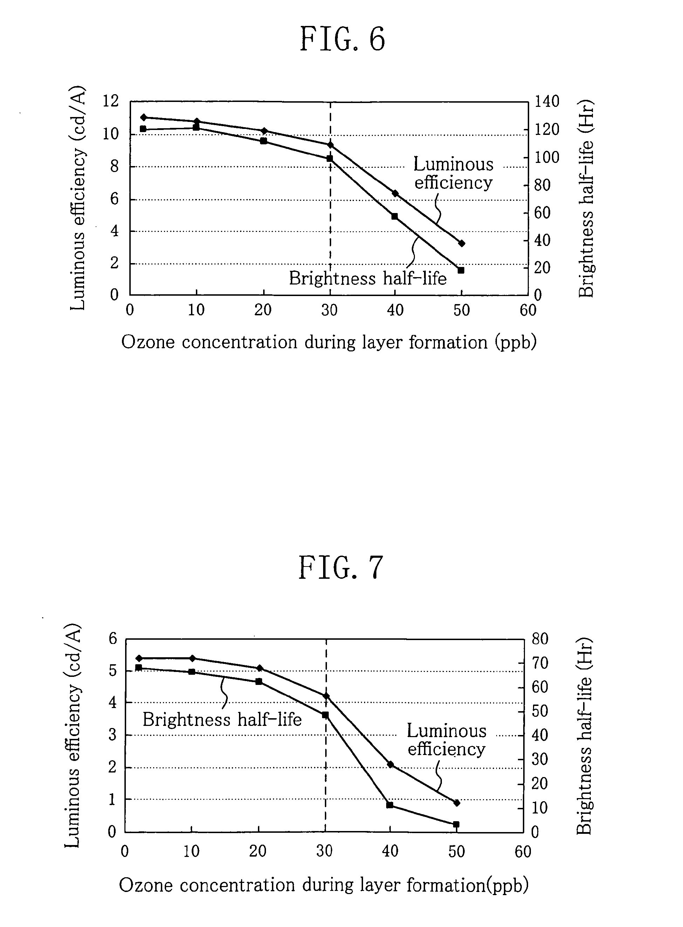

FIG. **6** is a graph showing the correlation between the ozone concentration during the formation of an organic EL layer (a buffer layer **43** and an organic EL light emitting layer **44)** and luminous efficiency for each of the implementation examples 1 through 4 and the comparison examples 1 and 2 in which a green light emitting material was used.

FIG. 7 is a graph showing the correlation between the ozone concentration during the formation of an organic EL layer (a buffer layer **43** and an organic EL light emitting layer **44)** and luminous efficiency for each of the implementation examples 5 through 8 and the comparison examples 3 and 4 in which a blue light emitting material was used.

As seen from the results shown in FIGS. **6** and **7,** in both cases where a green light emitting material was used and where a blue light emitting material was used, the luminous efficiency of an organic EL display **40** was increased with a reduction in the ozone concentration during the formation of an organic EL layer. The luminous efficiency is sharply changed, in particular, when the ozone concentration was in the range from 30 ppb to 50 ppb. When the ozone concentration exceeds 30 ppb, the obtained luminous efficiency sharply decreases. It has been found that when the ozone concentration is 30 ppb or less, high luminous efficiency can be achieved. In this case, the high luminous efficiency is equivalent to approximately 80 percent or more of the luminous efficiency provided when an organic EL layer is formed under an atmosphere that substantially does not contain ozone (3ppb or less).

It is particularly preferable that the ozone concentration during the formation of an organic EL layer is 20 ppb or less. It has been found that when the ozone concentration is 20 ppb or less, high luminous efficiency can be achieved. In this case, the high luminous efficiency is equivalent to approximately 90 percent or more of the luminous efficiency provided when an organic EL layer is formed under an atmosphere that substantially does not contain ozone (3ppb or less).

As illustrated in FIGS. **6** and **7,** it has been found that, like the luminous efficiency, the brightness half-life is also increased with a reduction in the ozone concentration during the formation of an organic EL layer. The brightness half-life is sharply changed, in particular, when the ozone concentration was in the range from 30 ppb to 50 ppb. When the ozone concentration exceeds 30 ppb, the brightness half-life sharply decreases. It has been found that when the ozone concentration is 30 ppb or less, a long brightness half-life can be achieved. In this case, the long brightness half-life is equivalent to approximately 70 percent or more of the brightness half-life provided when an organic EL layer is formed under an atmosphere that substantially does not contain ozone (3ppb or less).

Also from the viewpoint of providing a long brightness half-life, it is particularly preferable that the ozone concentration during the formation of an organic EL layer is 20 ppb or less. It has been found that when the ozone concentration is 20 ppb or less, a long brightness half-life can be achieved. In this case, the long brightness half-life is equivalent to approximately 90 percent or more of the brightness half-life provided when an organic EL layer is formed under an atmosphere that substantially does not contain ozone (3ppb or less).

### INDUSTRIAL APPLICABILITY

As described above, according to a method for fabricating an organic EL display of the present invention, an organic EL display having a long life can be fabricated. Therefore, the inventive fabrication method is useful to a cellular phone, a PDA, a TV, an electric book, a monitor, an electric poster, a watch, an electric inventory tag, an emergency guidance, and other products.

## Claims

1. A method for fabricating an organic electroluminescent display including an organic electroluminescent layer provided between a pair of electrodes, the method comprising the formation step of forming the organic electroluminescent layer in an electroluminescent layer formation chamber including an air atmosphere having a lower ozone concentration than the ambient atmosphere.

2. The method of Claim 1 further comprising the sending step of sending adjusted air having a lower ozone concentration than the ambient atmosphere into the electroluminescent layer formation chamber, the sending step being carried out prior to or simultaneously with the formation step.

3. The method of Claim 2, wherein
the sending step includes the adjustment step of adjusting the ozone concentration in the adjusted air using an ozone reducer for reducing the ozone concentration.

4. The method of Claim 3, wherein
the ozone reducer has the functions of decomposing ozone and absorbing ozone.

5. The method of Claim 3, wherein
the ozone reducer is an ozone filter.

6. The method of Claim 1 further comprising the reduction step of allowing the electroluminescent layer formation chamber to have a lower ozone concentration than the ambient atmosphere, the reduction step being carried out prior to or simultaneously with the formation step.

7. The method of Claim 1, wherein
the electroluminescent layer formation chamber has an ozone concentration of 30 ppb or less during the formation of the organic electroluminescent layer.

8. An organic electroluminescent display fabricated by the method of Claim 1.

9. A fabrication apparatus for an organic electroluminescent display including an organic electroluminescent layer, said apparatus comprising
an electroluminescent layer formation chamber for forming the organic electroluminescent layer, and
an adjusted air injector for sending adjusted air having a lower ozone concentration than the ambient atmosphere into the electroluminescent layer formation chamber during the formation of the organic electroluminescent layer.

10. The apparatus of Claim 9, wherein
the adjusted air injector includes an ozone reducer for reducing the ozone concentration.

11. The apparatus of Claim 10, wherein
the ozone reducer has the functions of decomposing ozone and absorbing ozone.

12. The apparatus of Claim 10, wherein
the ozone reducer is an ozone filter.

13. The apparatus of Claim 9, wherein
the electroluminescent layer formation chamber has an ozone concentration of 30 ppb or less during the formation of the organic electroluminescent layer.

14. The apparatus of Claim 9, wherein
the adjusted air injector includes a pump for sending air by the application of pressure and an ozone filter through which the air passes.

15. A fabrication apparatus for an organic electroluminescent display including an organic electroluminescent layer, said apparatus comprising
an electroluminescent layer formation chamber for forming the organic electroluminescent layer, and
an ozone reducer for allowing the electroluminescent layer formation chamber to have a lower ozone concentration than the ambient atmosphere during the formation of the organic electroluminescent layer.

16. The apparatus of Claim 15, wherein
the ozone reducer has the functions of decomposing ozone and absorbing ozone.

17. The apparatus of Claim 15, wherein
the electroluminescent layer formation chamber has an ozone concentration of 30 ppb or less during the formation of the organic electroluminescent layer.

18. The apparatus of Claim 15, wherein
the ozone reducer is an ozone filter.
